# FASCICULE DE BREVET EUROPEEN

(11) **EP 3 752 657 B1**
(45) Date de publication et mention de la délivrance du brevet: **27.10.2021**
(21) Numéro de dépôt: 19703744.3
(22) Date de dépôt: 13.02.2019
(51) Int. Cl.: C23C 18/16, C23C 18/38, C23C 18/32, H05K 3/18, H01L 21/288, H01L 21/768, H05K 3/42

(54) **PROCEDE DE METALLISATION DE TROUS D'UN MODULE ELECTRONIQUE PAR DEPOT EN PHASE LIQUIDE**
VERFAHREN ZUR METALLISIERUNG VON LÖCHERN EINES ELEKTRONISCHEN MODULS DURCH FLÜSSIGPHASENABSCHEIDUNG
METHOD FOR METALLISING HOLES OF AN ELECTRONIC MODULE BY LIQUID PHASE DEPOSITION

(30) Priorité: 14.02.2018 FR 1851215
(43) Date de publication de la demande: 23.12.2020
(73) Titulaire: 3D Plus, 78530 Buc Cedex (FR)
(72) Inventeur: VAL, Christian, 78470 Saint-Rémy-les-Chevreuse (FR)
(74) Mandataire: Marks & Clerk France
(86) Numéro de dépôt international: PCT/EP2019/053548
(87) Numéro de publication internationale: WO 2019/158585

(56) Documents cités:
- JP-A- S6 112 877
- JP-A- H04 280 978
- JP-A- H07 197 268
- JP-A- H09 307 239
- JP-A- S63 277 771
- JP-A- 2007 262 542
- JP-A- 2010 159 469

## Description

Le domaine de l'invention est celui des circuits électroniques, qu'il s'agisse de circuits imprimés (Printed Circuit Board ou PCB) ou de modules électroniques 3D c'est-à-dire ayant plusieurs niveaux de composants empilés. Certains modules électroniques (PCB ou 3D) sont munis de trous percés verticalement c'est-à-dire selon l'épaisseur du module. En effet, un circuit imprimé ou un module 3D comporte plusieurs niveaux horizontaux comportant des composants et des conducteurs électriques ; les trous métallisés souvent désignés vias traversent ces niveaux et permettent ainsi de connecter verticalement ces conducteurs entre eux par contact entre les trous métallisés et les sections de ces conducteurs affleurant au niveau des trous. Dans la suite on désigne par trou, un trou borgne (non traversant ou « blind hole » en anglais) ou un trou traversant. Bien sûr un module électronique peut comporter des trous borgnes et des trous traversants.

On utilise depuis l'origine la technologie de dépôt chimique sans courant pour métalliser ces trous et obtenir une couche métallique, avec éventuellement une étape de recharge électrochimique pour compléter la couche métallique alors désignée couche d'accrochage. Les progrès du dépôt chimique sans courant font qu'il est possible de déposer une couche de plusieurs microns sans passer par le dépôt électrochimique.

Il est connu de métalliser des trous par dépôt en phase liquide en immergeant le circuit imprimé ou le module électronique 3D dans un liquide comportant des composés métalliques qui libèrent des atomes métalliques venant se déposer sur les parois des trous pour former la couche métallique voulue.

La métallisation des parois de trous par dépôt en phase liquide, devient d'autant plus difficile que les trous ont un petit diamètre (horizontal) comparativement à leur profondeur (verticale). Le diamètre des trous intervient directement dans le rendement de dépôt ; on considère plus particulièrement des trous de petits diamètres, c'est-à-dire de 80 µm ou plus. Des PCB ou des modules 3D peuvent avoir des épaisseurs de 1 à plusieurs millimètres d'épaisseur. Des ratios de forme R entre la profondeur du trou et son diamètre, supérieurs à 10 peuvent donc être atteints.

Plus le ratio de forme R entre la profondeur du trou et son diamètre s'accroît, plus la difficulté pour métalliser régulièrement ses parois en épaisseur et en composition s'accentue. Un ratio de forme R atteignant 10 pour un trou dont le diamètre serait de 100 µm est considéré comme impossible à réaliser. Le document JPH04280978 divulgue un procédé de dépôt en phase liquide de couches métalliques dans des trous d'un module électronique.

Le but de l'invention est de pallier ces inconvénients. En conséquence, il demeure à ce jour un besoin pour un procédé donnant simultanément satisfaction à l'ensemble des exigences précitées, en termes de métallisation de trous à facteur de forme R>10 et notamment de petits diamètres, d'un module électronique.

Le procédé selon l'invention est basé sur un dépôt en plusieurs couches.

Plus précisément l'invention a pour objet un procédé de dépôt en phase liquide de couches métalliques dans des trous d'un module électronique disposé dans une enceinte hermétique, à partir d'un liquide chimique à composés métalliques destinés à former une couche métallique. Il est principalement caractérisé en ce que les trous ont une profondeur P et un diamètre D tels que D>80 µm et P/D > 10, et en ce que le procédé comporte au moins un cycle comportant les sous-étapes suivantes :
- M1) Mise sous une pression prédéterminée P0 de l'enceinte et remplissage de l'enceinte par le liquide,
- M2) Dégazage des trous par mise sous une pression réduite P1 de l'enceinte, avec P1<P0,
- M3) Remise à la pression P0 de l'enceinte et remplissage de l'enceinte avec le liquide,
- M4) Dépôt dans les trous d'une couche métallique issue du liquide,
- M5) Vidage du liquide de l'enceinte,
- M6) Evaporation explosive du liquide restant dans les trous par mise sous une pression réduite P2 de l'enceinte, avec P2<P1 <P0,
et en ce que le cycle comportant les sous-étapes M1 à M6, est réitéré au moins une fois pour obtenir une nouvelle couche métallique par itération.

De préférence, préalablement au premier cycle, il comporte une sous-étape de séchage des trous par mise sous une pression réduite Pmin de l'enceinte, avec Pmin<P2.

Préalablement à ce cycle de dépôt et à cette sous-étape de séchage, il comporte éventuellement plusieurs étapes préalables, dites de préparation avant dépôt, qui sont dans l'ordre :
- une étape de nettoyage des trous réalisée avec un liquide de nettoyage,
- une étape de gravure de sections de conducteurs interceptées par les trous, avec un liquide de gravure,
- une étape de pré-trempage avec un liquide de pré-trempage améliorant le mouillage,
- une étape d'activation des parois des trous avec un liquide de sensibilisation,
- une étape de bain réducteur avec un liquide basique.

Chaque étape préalable comprend avantageusement les sous-étapes suivantes réalisées avec un liquide spécifique de ladite étape préalable :
- séchage des trous par mise sous une pression réduite Pmin de l'enceinte, avec Pmin<P2,
- remplissage de l'enceinte par le liquide spécifique de l'étape préalable sous une pression P0,
- dégazage des trous par mise sous une pression réduite P1 de l'enceinte, avec P1<P0,
- remplissage de l'enceinte avec le liquide spécifique de l'étape préalable, sous une pression P0,
- action du liquide spécifique de l'étape préalable pendant une durée déterminée,
- vidage de l'enceinte,
- évaporation explosive du liquide restant dans les trous par mise sous une pression réduite P2 de l'enceinte, avec P2<P1<P0.

Il comprend avantageusement entre chaque étape préalable, une sous-étape de rinçage de l'enceinte.

On a par exemple P0 égale à la pression atmosphérique.

L'invention a aussi pour objet un dispositif de mise en œuvre du procédé tel que décrit, caractérisé en ce qu'il comprend :
- une enceinte hermétique configurée pour recevoir au moins un module électronique,
- une réserve à vide régulée en pression, connectée à une pompe à vide et reliée à l'enceinte par un piège à liquide,
- un réservoir du liquide commandé par une pompe à liquide, et relié à l'enceinte par un tuyau de remplissage de l'enceinte et un tuyau de vidage de l'enceinte.

D'autres caractéristiques et avantages de l'invention apparaîtront à la lecture de la description détaillée qui suit, faite à titre d'exemple non limitatif et en référence aux dessins annexés dans lesquels :
les figures 1 représentent schématiquement en fonction du temps l'évolution de l'épaisseur d'une couche métallique (fig 1a), l'évolution de la concentration en composés métalliques d'une couche (fig 1b),
la figure 2 représente schématiquement un diagramme de pression des gaz dans l'enceinte en fonction de la durée et les sous-étapes correspondantes, pour l'étape de métallisation,
la figure 3 illustre l'enchaînement des étapes du procédé de métallisation avec les étapes préalables de préparation,
la figure 4 représente schématiquement un exemple de dispositif de mise en œuvre du procédé selon l'invention, vue en coupe.

D'une figure à l'autre, les mêmes éléments sont repérés par les mêmes références.

Dans la suite de la description, les expressions « horizontal », « vertical », sont utilisées en référence à l'orientation des figures décrites. Dans la mesure où le dispositif peut être positionné selon d'autres orientations, la terminologie directionnelle est indiquée à titre d'illustration et n'est pas limitative.

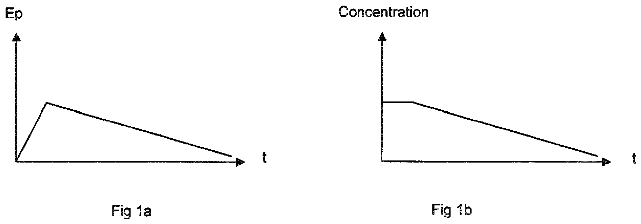

Pour des trous à facteur de forme R >10, le liquide remplissant chaque trou n'est pas renouvelé ou brassé comme dans une installation classique pour PCB ayant des trous à facteur de forme R<10, ce qui entraîne une variation des propriétés du dépôt métallique sur les parois des trous durant cette phase de métallisation : l'épaisseur de dépôt sur ces parois diminue avec le temps, ainsi que la concentration en composés métalliques comme illustré sur les figures 1a et 1b. Il en résulte que la concentration en composés métalliques de la couche déposée sur les parois des trous (à facteur de forme R>10) n'est pas uniforme selon son épaisseur et l'épaisseur de cette couche est limitée.

La solution selon l'invention est basée sur un renouvellement du liquide à l'intérieur des trous. Ainsi plusieurs couches métalliques uniformes vont être déposées les unes sur les autres, à raison d'une nouvelle couche par renouvellement du liquide, pour finalement obtenir sur les parois de chaque trou, une couche finale (= somme des couches déposées les unes sur les autres) d'épaisseur et de concentration uniformes.

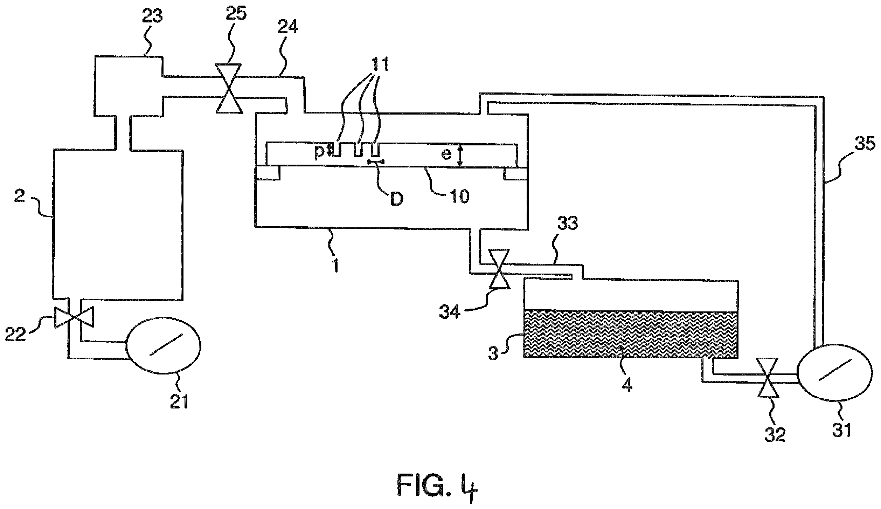

On va à présent décrire plus en détail le procédé de métallisation selon l'invention. Le module électronique (PCB ou module 3D) 10 muni de trous 11 de profondeur P (selon l'épaisseur e du module) et de diamètre D, est tout d'abord placé horizontalement ou verticalement dans une enceinte hermétique 1 comme on peut le voir figure 4.

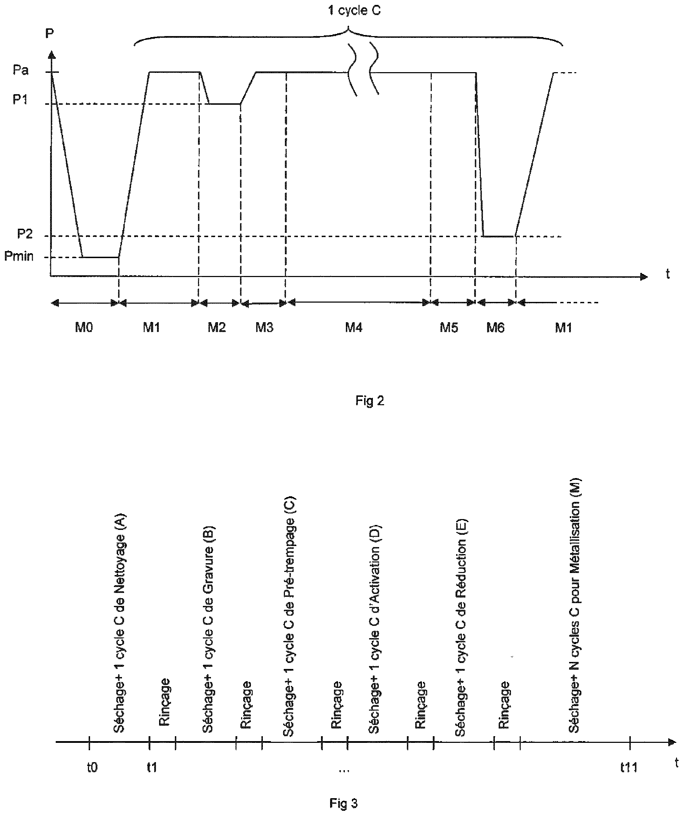

Un cycle Cyc de sous-étapes séquentielles indiquées figure 2 est alors effectué :
M1) Mise sous pression P0 de l'enceinte, par exemple la pression atmosphérique (P0=Pa) ou une pression supérieure ; en effet, le fait de pouvoir accroitre la pression au-dessus de la pression atmosphérique a les avantages suivants : accroissement de la conductivité électrique du dépôt et de sa vitesse de dépôt. Après la mise sous pression P0 de l'enceinte, remplissage de l'enceinte 1 par un liquide chimique à composés métalliques destinés à former la couche métallique ; les composés métalliques sont typiquement des composés de cuivre ou de nickel ou d'aluminium ou d'autres métaux.
M2) Une fois l'enceinte 1 remplie, dégazage des trous 11 immergés dans le liquide 4 par abaissement de la pression P0 à P1 dans l'enceinte, la pression P1 étant maintenue pendant une durée prédéterminée pour réaliser ce dégazage, la différence de pression (P0 - P1) étant d'environ 50 à 100 mbars. Une différence de pression plus importante éliminerait trop de liquide par évaporation.
M3) Remise de l'enceinte 1 à la pression P0, et remplissage de l'enceinte avec le liquide 4,
M4) Action du liquide sur le module et ses trous, soit en l'occurrence opération dite de dépôt chimique en phase liquide comme réalisé habituellement pour la métallisation des PCB ; ce dépôt est effectué pendant une durée permettant que la concentration en composés de la couche déposée soit uniforme : l'opération est donc stoppée juste avant que la concentration en composés du liquide 4 ne commence à baisser,
M5) Vidage du liquide 4 de l'enceinte 1,
M6) Evaporation « explosive » du liquide 4 piégé dans les trous 11 : une dépression importante (P0 - P2) pouvant atteindre plusieurs centaines de mbars (on a par exemple 500 mbars<P2<700 mbars) est appliquée dans l'enceinte 1 et maintien de cette pression P2 pendant 2 à 10 secondes, afin que le liquide 4 piégé dans les trous 11 soit vaporisé complètement et en un temps très court (évaporation explosive) de façon à entrainer d'éventuelles particules fines non adhérentes qui seraient tombées au fond des trous.

A l'issue de ce cycle Cyc de sous-étapes M1 à M6, une couche métallique est ainsi déposée sur les parois des trous 11 des circuits imprimés ou des modules 3D.

Ce cycle Cyc est réitéré de la même façon (mêmes pressions, même liquide renouvelé, et généralement mêmes durées des sous-étapes) de manière à obtenir une nouvelle couche métallique à chaque itération, ces couches étant uniformes. Le nombre N de cycles Cyc est déterminé par l'épaisseur de la couche finale (=somme des couches) à atteindre et est lié aussi à la concentration métallique du liquide de dépôt ; en effet en deçà d'une certaine concentration, par exemple comprise entre 25% et 50%, un renouvellement du liquide et donc un nouveau cycle est nécessaire. On a couramment N compris entre 5 et 20. Cet ensemble de N cycles dure typiquement entre 1h et 2.5h, la sous-étape M4 étant bien sûr la plus longue des sous-étapes. On désigne par étape de métallisation des trous cet ensemble de N cycles Cyc.

De préférence, avant le premier cycle Cyc, une étape M0 de séchage des trous 11 est effectuée par dégazage sous vide poussé Pmin de l'enceinte et maintien de cette pression Pmin, de façon à éliminer l'éventuelle présence d'eau sur les parois des trous. On a par exemple 1 mbar<Pmin<100 mbars.

Toutes ces sous-étapes se font sous atmosphère neutre par exemple avec de l'air sec ou de l'azote de façon à ne pas oxyder les dépôts partiels formés à chaque cycle.

De préférence, préalablement au premier cycle, c'est-à-dire préalablement à cette étape de métallisation des trous, différentes étapes sont réalisées, qui visent à préparer l'étape de métallisation ; elles sont montrées figure 3. Il s'agit des étapes de :
- A) nettoyage des trous 11 avec un liquide 4 de nettoyage, pour nettoyer notamment les matériaux non métalliques tels que par exemple la résine de moulage et le diélectrique,
- B) gravure des sections de conducteurs électriques horizontaux, interceptées par les trous 11 avec un liquide 4 acide de gravure, pour améliorer l'adhérence de ces sections avec la future métallisation des trous,
- C) pré-trempage des trous 11 avec un liquide 4 de pré-trempage, pour améliorer la mouillabilité des parois des trous 11 en vue de l'étape suivante,
- D) activation des parois des trous 11 avec un liquide 4 catalyseur de sensibilisation (liquide du commerce), souvent de type Palladium,
- E) réduction dans un bain réducteur avec un liquide basique 4 du commerce, pour réduire en atomes les ions créés par l'étape précédente (ions Palladium par exemple) et préparer la réaction catalytique du métal (cuivre ou nickel ou aluminium dans notre exemple) sans courant.

Aucun dépôt d'une couche n'est obtenu à l'issue de ces étapes A) à E).

Chacune de ces étapes dure entre 25 et 250 secondes, et comporte les sous-étapes suivantes réalisées avec le liquide spécifique de l'étape :
- dégazage sous vide poussé Pmin de l'enceinte 1 de façon à éliminer l'éventuelle présence d'eau sur les parois des trous 11,
- mise sous pression P0 de l'enceinte et remplissage de l'enceinte 1 par le liquide 4 spécifique de l'étape,
- une fois l'enceinte remplie, dégazage des trous 11 immergés dans le liquide 4 par abaissement de la pression P0 à P1 dans l'enceinte 1, la pression P1 étant maintenue pendant une durée prédéterminée pour réaliser ce dégazage,
- remise de l'enceinte 1 à la pression P0, et remplissage de l'enceinte 1 avec le liquide 4 spécifique de l'étape,
- action du liquide c'est-à-dire que le liquide 4 spécifique de l'étape est laissé dans l'enceinte 1 le temps que la fonction de l'étape (nettoyage ou gravure ou pré-trempage ou activation ou réduction) soit réalisée ; la durée de cette étape varie en fonction de l'étape,
- vidage du liquide 4 de l'enceinte 1,
- évaporation « explosive » du liquide 4 piégé dans les trous 11 : une dépression importante (Pa - P2) pouvant atteindre plusieurs centaines de mbars est appliquée dans l'enceinte 1 et maintien de cette pression P2, afin que le liquide 4 piégé dans les trous soit vaporisé complètement et en un temps très court (évaporation explosive).

On retrouve dans ces sous-étapes, les sous-étapes d'un cycle Cyc de métallisation M1 à M6 avec aussi l'étape préalable de séchage M0 ; ces sous-étapes diffèrent cependant par le liquide utilisé ainsi que par les durées de ces sous-étapes, qui varient d'une étape à l'autre. Comme déjà indiqué le liquide de nettoyage diffère du liquide de gravure, etc ; de même la durée de la sous-étape de dégazage des trous immergés dans le liquide pour l'étape d'activation n'est pas nécessairement identique à celle de la même sous-étape de dégazage pour l'étape de réduction, etc. Les liquides utilisés sont typiquement des liquides disponibles dans le commerce.

De préférence comme montré figure 3, le procédé comprend entre chacune des étapes A) à E), une sous-étape de rinçage de l'enceinte 1, par exemple avec de l'eau désionisée.

Toutes ces sous-étapes des étapes A à E peuvent être effectuées sous atmosphère neutre par exemple avec de l'air sec ou de l'azote.

Ces sous-étapes et étapes (A à E ou M) sont avantageusement automatisées.

On a par exemple comme valeurs de pressions (quelle que soit l'étape A à E ou M) :
1mbar<Pmin<100 mbar,
500 mbars<P2<700 mbars,
900 mbars<P1<950 mbars,
Pa≤P0 ≤ 150 bars, Pa étant la pression atmosphérique égale à environ 1000 mbars.

Ces étapes sont avantageusement réalisées en utilisant le même équipement 100 dont un exemple est décrit en relation avec la figure 4. Il comporte :
- Une enceinte hermétique 1 dans laquelle est placé le module électronique 10 (circuit imprimé ou module électronique 3D) qui comprend des trous 11 (sur la figure on a représenté des trous 11 borgnes) ; plusieurs circuits imprimés ou modules 3D peuvent être installés dans l'enceinte 1.
- Une réserve à vide 2 régulée en pression et connectée à une pompe à vide 21 assortie d'une vanne 22 et reliée à l'enceinte 1 à travers un piège à liquide 23 et un tuyau 24 muni d'une vanne 25.
Un réservoir 3 de liquide (ce liquide 4 varie selon l'étape à réaliser comme indiqué précédemment) commandé par une pompe à liquide 31 assortie d'une vanne 32, relié à l'enceinte par un tuyau 33 de vidage de l'enceinte muni d'une vanne 34 et un tuyau 35 de remplissage de l'enceinte.

D'une étape à l'autre le liquide 4 utilisé est le liquide spécifique de l'étape. Pour les cycles successifs de l'étape M de métallisation, le liquide 4 qui est le liquide chimique à composés métalliques, est renouvelé.

Réaliser ces étapes (A à E et M) dans un équipement fermé, c'est-à-dire sans contact avec l'extérieur, conduit aux avantages industriels suivants : pas de pollution dans les locaux et donc, pas d'aspiration et de traitement de l'air pour débarrasser celui-ci des gaz nocifs issus de ces bains de dépôt chimique.

## Revendications

1. Procédé de dépôt en phase liquide de couches métalliques dans des trous (11) d'un module électronique (10) disposé dans une enceinte hermétique (1), à partir d'un liquide (4) chimique à composés métalliques destinés à former une couche métallique, **caractérisé en ce que** les trous ont une profondeur P et un diamètre D tels que D>80 µm et P/D > 10, et **en ce que** le procédé comporte au moins un cycle (Cyc) comportant les sous-étapes suivantes :
- M1) Mise sous une pression prédéterminée P0 de l'enceinte et remplissage de l'enceinte par le liquide,
- M2) Dégazage des trous par mise sous une pression réduite P1 de l'enceinte, avec P1<P0,
- M3) Remise à la pression P0 de l'enceinte et remplissage de l'enceinte avec le liquide,
- M4) Dépôt dans les trous d'une couche métallique issue du liquide,
- M5) Vidage du liquide de l'enceinte,
- M6) Evaporation explosive du liquide restant dans les trous par mise sous une pression réduite P2 de l'enceinte, avec P2<P1<P0,
réitération au moins une fois du cycle (Cyc) comportant les sous-étapes M1 à M6 pour obtenir une nouvelle couche métallique par itération.

2. Procédé de dépôt de couches métalliques selon la revendication précédente, **caractérisé en ce que** préalablement au premier cycle (Cyc), il comporte une sous-étape (M0) de séchage des trous par mise sous une pression réduite Pmin de l'enceinte, avec Pmin<P2.

3. Procédé de dépôt de couches métalliques selon la revendication précédente, **caractérisé en ce que** préalablement à la sous-étape de séchage (M0), il comporte plusieurs étapes préalables de préparation qui sont dans l'ordre :
- A) nettoyage des trous réalisée avec un liquide (4) de nettoyage,
- B) gravure de sections de conducteurs interceptées par les trous, avec un liquide (4) de gravure,
- C) pré-trempage avec un liquide (4) de pré-trempage,
- D) activation des parois des trous avec un liquide (4) catalyseur,
- E) réduction dans un bain réducteur avec un liquide (4) réducteur.

4. Procédé de dépôt de couches métalliques selon la revendication précédente, **caractérisé en ce que** chaque étape préalable (A, B, C, D, E) comprend les sous-étapes suivantes réalisées avec un liquide (4) spécifique de ladite étape préalable :
- séchage des trous par mise sous une pression réduite Pmin de l'enceinte, avec Pmin<P2,
- remplissage de l'enceinte par le liquide spécifique de l'étape préalable sous la pression P0,
- dégazage des trous par mise sous une pression réduite P1 de l'enceinte, avec P1<P0,
- remplissage de l'enceinte avec le liquide spécifique de l'étape préalable, sous la pression P0,
- action du liquide spécifique de l'étape préalable pendant une durée déterminée,
- vidage de l'enceinte,
- évaporation explosive du liquide spécifique restant dans les trous par mise sous une pression réduite P2 de l'enceinte, avec P2<P1<P0.

5. Procédé de dépôt de couches métalliques selon la revendication précédente, **caractérisé en ce qu'**il comprend entre chaque étape préalable (A, B, C, D, E), une sous-étape de rinçage de l'enceinte.

6. Procédé de dépôt de couches métalliques selon l'une des revendications précédentes, **caractérisé en ce que** la pression P0 est la pression atmosphérique.

7. Procédé de dépôt de couches métalliques selon l'une des revendications précédentes, **caractérisé en ce que** les composés métalliques sont des composés de cuivre ou de nickel ou d'aluminium.

8. Procédé de dépôt de couches métalliques selon l'une des revendications précédentes, **caractérisé en ce que** des trous (11) sont borgnes.

9. Dispositif de mise en œuvre du procédé de dépôt de couches métalliques selon l'une des revendications précédentes comprenant:
- une enceinte hermétique (1) configurée pour recevoir au moins un module électronique (10) comportant des trous (11),
-
- un réservoir (3) du liquide (4) commandé par une pompe à liquide (31), et relié à l'enceinte (1) par un tuyau de remplissage (35) et un tuyau de vidage (33),
**caractérisé en ce qu'**il comprend une réserve à vide (2) régulée en pression, connectée à une pompe à vide (21) et reliée à l'enceinte (1) par un piège (23) à liquide.

## Patentansprüche

1. Verfahren zur Flüssigphasenabscheidung von Metallschichten in Löchern (11) eines elektronischen Moduls (10), das in einer hermetischen Kammer (1) angeordnet ist, aus einer chemischen Flüssigkeit (4) mit zum Bilden einer Metallschicht bestimmten Metallverbindungen, **dadurch gekennzeichnet, dass** die Löcher eine Tiefe P und einen Durchmesser D aufweisen, so dass D>80 µm und P/D > 10 ist, und dadurch, dass das Verfahren mindestens einen Zyklus (Cyc) mit den folgenden Teilschritten aufweist:
- M1) Beaufschlagen der Kammer mit einem vorgegebenen Druck P0 und Füllen der Kammer mit der Flüssigkeit,
- M2) Entgasen der Löcher durch Beaufschlagen der Kammer mit einem reduzierten Druck P1, wobei P1<P0,
- M3) Zurücksetzen des Drucks in der Kammer auf P0 und Füllen der Kammer mit der Flüssigkeit,
- M4) Abscheiden einer Metallschicht aus der Flüssigkeit in den Löchern,
- M5) Entleeren der Flüssigkeit aus der Kammer,
- M6) explosives Verdampfen der in den Löchern verbliebenen Flüssigkeit durch Beaufschlagen der Kammer mit einem reduzierten Druck P2, wobei P2<P1<P0,
mindestens einmaliges Wiederholen des Zyklus (Cyc) mit den Teilschritten M1 bis M6, um durch Iteration eine neue Metallschicht zu erhalten.

2. Verfahren zum Abscheiden von Metallschichten nach dem vorherigen Anspruch, **dadurch gekennzeichnet, dass** es vor dem ersten Zyklus (Cyc) einen Teilschritt (M0) des Trocknens der Löcher durch Beaufschlagen der Kammer mit einem reduzierten Druck Pmin beinhaltet, wobei Pmin<P2.

3. Verfahren zum Abscheiden von Metallschichten nach dem vorherigen Anspruch, **dadurch gekennzeichnet, dass** es vor dem Trocknungsteilschritt (M0) mehrere Vorabschritte in der folgenden Reihenfolge beinhaltet:
- A)Reinigen der Löcher mithilfe einer Reinigungsflüssigkeit (4),
- B)Ätzen von durch die Löcher unterbrochenen Leiterabschnitten mit einer Ätzflüssigkeit (4),
- C)Voreinweichen mit einer Voreinweichungsflüssigkeit (4),
- D)Aktivieren der Lochwände mit einer Katalysatorflüssigkeit (4),
- E)Reduzieren in einem Reduktionsbad mit einer Reduktionsflüssigkeit (4).

4. Verfahren zum Abscheiden von Metallschichten nach dem vorherigen Anspruch, **dadurch gekennzeichnet, dass** jeder Vorabschritt (A, B, C, D, E) die folgenden Teilschritte umfasst, die mit einer für den Vorabschritt spezifischen Flüssigkeit (4) durchgeführt werden:
- Trocknen der Löcher durch Beaufschlagen der Kammer mit einem reduzierten Druck Pmin, wobei Pmin<P2,
- Füllen der Kammer mit der spezifischen Flüssigkeit aus dem Vorabschritt unter dem Druck P0,
- Entgasen der Löcher durch Beaufschlagen der Kammer mit einem reduzierten Druck P1, wobei P1<P0,
- Füllen des Behälters mit der spezifischen Flüssigkeit aus dem Vorabschritt unter dem Druck P0,
- Wirkenlassen der spezifischen Flüssigkeit aus dem Vorabschritt für einen bestimmten Zeitraum,
- Entleeren der Kammer,
- explosives Verdampfen der in den Löchern verbliebenen spezifischen Flüssigkeit durch Beaufschlagen der Kammer mit einem reduzierten Druck P2, wobei P2<P1<P0.

5. Verfahren zum Abscheiden von Metallschichten nach dem vorherigen Anspruch, **dadurch gekennzeichnet, dass** es zwischen jeweiligen Vorabschritten (A, B, C, D, E) einen Teilschritt des Spülens der Kammer umfasst.

6. Verfahren zum Abscheiden von Metallschichten nach einem der vorherigen Ansprüche, **dadurch gekennzeichnet, dass** der Druck P0 Atmosphärendruck ist.

7. Verfahren zum Abscheiden von Metallschichten nach einem der vorherigen Ansprüche, **dadurch gekennzeichnet, dass** die Metallverbindungen Kupfer- oder Nickel- oder Aluminiumverbindungen sind.

8. Verfahren zum Abscheiden von Metallschichten nach einem der vorherigen Ansprüche, **dadurch gekennzeichnet, dass** die Löcher (11) blind sind.

9. Vorrichtung zur Durchführung des Verfahrens zum Abscheiden von Metallschichten nach einem der vorherigen Ansprüche, die Folgendes umfasst:
- eine hermetische Kammer (1), konfiguriert zum Aufnehmen mindestens eines elektronischen Moduls (10) mit Löchern (11),
- ein Reservoir (3) für die Flüssigkeit (4), das durch eine Flüssigkeitspumpe (31) gesteuert wird und mit der Kammer (1) durch eine Füllleitung (35) und eine Entleerungsleitung (33) verbunden ist,
**dadurch gekennzeichnet, dass** sie einen druckgeregelten Vakuumtank (2) umfasst, der an eine Vakuumpumpe (21) angeschlossen und über eine Flüssigkeitsfalle (23) mit der Kammer (1) verbunden ist.

## Claims

1. Liquid-phase method for depositing metal layers in holes (11) of an electronic module (10) placed in a hermetic chamber (1), from a chemical liquid (4) having metal compounds intended to form a metal layer, **characterized in that** the holes have a depth P and a diameter D such that D>80 µm and P/D > 10, and **in that** the method has at least one cycle (Cyc) having the following substeps:
- M1) Bringing the chamber to a preset pressure P0 and filling the chamber with the liquid,
- M2) Degassing the holes by bringing the chamber to a low pressure P1, with P1<P0,
- M3) Returning the chamber to the pressure P0 and filling the chamber with the liquid,
- M4) Depositing, in the holes, a metal layer issued from the liquid,
- M5) Emptying the liquid from the chamber,
- M6) Explosively evaporating the liquid remaining in the holes by bringing the chamber to a low pressure P2, with P2<P1<P0,
reiterating the cycle (Cyc) having the substeps M1 to M6 at least once to obtain one new metal layer through iteration.

2. Method for depositing metal layers according to the preceding claim, **characterized in that**, prior to the first cycle (Cyc), it contains a substep (M0) of drying the holes by bringing the chamber to a low pressure Pmin, with Pmin<P2.

3. Method for depositing metal layers according to the preceding claim, **characterized in that**, prior to the drying substep (M0), it contains several prior preparing steps, namely, in order:
- A) cleaning the holes with a cleaning liquid (4),
- B) etching of conductor segments intercepted by the holes, with an etchant liquid (4),
- C) pre-dipping with a pre-dip liquid (4),
- D) activating the walls of the holes with a catalyzer liquid (4),
- E) reducing in a reducing bath with a reducer liquid (4).

4. Method for depositing metal layers according to the preceding claim, **characterized in that** each prior step (A, B, C, D, E) comprises the following substeps carried out with a specific liquid (4) of said prior step:
- drying the holes by bringing the chamber to a low pressure Pmin, with Pmin<P2,
- filling the chamber with the specific liquid of the prior step at the pressure P0,
- degassing the holes by bringing the chamber to a low pressure P1, with P1<P0,
- filling the chamber with the specific liquid of the prior step, at the pressure P0,
- letting the specific liquid of the prior step act for a set length of time,
- emptying the chamber,
- explosively evaporating the specific liquid remaining in the holes by bringing the chamber to a low pressure P2, with P2<P1<P0.

5. Method for depositing metal layers according to the preceding claim, **characterized in that** it comprises, between each prior step (A, B, C, D, E), a substep of rinsing the chamber.

6. Method for depositing metal layers according to one of the preceding claims, **characterized in that** the pressure P0 is atmospheric pressure.

7. Method for depositing metal layers according to one of the preceding claims, **characterized in that** the metal compounds are copper or nickel or aluminium compounds.

8. Method for depositing metal layers according to one of the preceding claims, **characterized in that** there are blind holes (11).

9. Device for implementing the method for depositing metal layers according to one of the preceding claims, comprising:
- a hermetic chamber (1) configured to receive at least one electronic module (10) having holes (11),
- a reservoir (3) of the liquid (4), controlled by a liquid pump (31) and connected to the chamber (1) by a filling pipe (35) and an emptying pipe (33),
**characterized in that** it comprises a pressure-regulated vacuum cavity (2) that is connected to a vacuum pump (21) and that is connected to the chamber (1) by a liquid trap (23).
